# EUROPEAN PATENT APPLICATION

(11) **EP 4 845 355 A1**
(43) Date of publication of application: **25.11.2026**
(21) Application number: 25858715.3
(22) Date of filing: 03.07.2025
(51) Int. Cl.: H10F 77/20

(54) **SOLAR CELL AND CELL ASSEMBLY**

(30) Priority: 30.08.2024 CN 202411217218; 30.08.2024 CN 202411217039
(71) Applicant: Zhejiang Aiko Solar Technology Co., Ltd, Jinhua, Zhejiang 322009 (CN); Guangdong Aiko Solar Technology Co., Ltd, Foshan, Guangdong 528137 (CN); Tianjin Aiko Solar Technology Co., Ltd, Tianjin 300400 (CN); Zhuhai Fushan Aiko Solar Technology Co., Ltd, Zhuhai, Guangdong 519175 (CN); Shandong Aiko Solar Technology Co., Ltd, Jinan, Shandong 250000 (CN); Chuzhou Aiko Solar Technology Co., Ltd., Chuzhou, Anhui 239514 (CN)
(72) Inventor: JIANG, Fei, Jinhua, Zhejiang 322009 (CN); YANG, Xinqiang, Jinhua, Zhejiang 322009 (CN); XU, Yang, Jinhua, Zhejiang 322009 (CN); CHEN, Gang, Jinhua, Zhejiang 322009 (CN)
(74) Representative: EP&C
(86) International application number: PCT/CN2025/106923
(87) International publication number: WO 2026/045671

(57) **Abstract**

The present disclosure is applicable to the field of photovoltaic technologies. The present disclosure provides a solar cell and a cell assembly, the solar cell includes a plurality of first doped regions and second doped regions distributed in a staggered manner in a first direction; and a plurality of mark points, some of the plurality of mark points being provided in the first doped region, and others of the mark points being provided in the second doped region. The present disclosure avoids the problem of the mask at the mark point being easily damaged.

## Description

### Cross-Reference to Related Application

The present disclosure claims the priority of Chinese Patent Disclosure no. 202411217039.9 filed on August 30, 2024 and entitled "Solar Cell and Photovoltaic Module" and the priority of Chinese Patent Disclosure no. 202411217218.2 filed on August 30, 2024 and entitled "Solar Cell and Cell Assembly", the disclosure of which is incorporated herein by reference in its entirety.

### Technical Field

The present disclosure relates to the field of photovoltaic technologies, and in particular, to a solar cell and a cell assembly.

### Background

In the related art, when manufacturing back-contact cells, screen printing is performed after various processes to form electrodes. The screen mesh consists of warp threads and weft threads, which intersect perpendicularly. To avoid printing defects at the intersections of the warp threads and the weft threads, some weft threads in the patterns of the p-type region or the n-type region may be removed during the screen printing process to improve the printing quality of the grid lines. Typically, the grid lines of the p-type region or the n-type region and the mark points are printed in the same process step, so that the mark points are printed simultaneously with the grid lines of the p-type or n-type region. During repeated printing processes, the warp threads at the mark point position are prone to fracture. Without the support of the warp threads, the mask at the mark point position is quickly damaged due to repeated scraping by the squeegee. As a result, the mark point position is gradually enlarged, leading to leakage of slurry, which eventually causes the screen to be damaged and unusable.

### Summary

The present disclosure provides a solar cell, which aims at solving the problem in the prior art that the mask at the mark point position is quickly damaged during repeated scraping by the squeegee, causing the mark point position to gradually enlarge and leading to leakage of slurry, which eventually causes the screen to be damaged and unusable.

The present disclosure is implemented as follows: a solar cell, Including a silicon substrate, wherein the silicon substrate includes: a plurality of first doped regions and second doped regions distributed in a staggered manner in a first direction, the first doped region and the second doped region extend in a second direction, the first direction intersects with the second direction; first grid lines are provided in the first doped region, and second grid lines are provided in the second doped region; a plurality of mark points, some of the plurality of mark points being provided in the first doped region, and others of the mark points being provided in the second doped region.

In some implementations, at least some of the plurality of mark points are provided between the first grid lines and the second grid lines.

In some implementations, some of the plurality of mark points are provided below the first grid lines, and others of the plurality of mark points being provided above the second grid lines.

In some implementations, the silicon substrate has a first central axis in the first direction and a second central axis in the second direction, with the intersection of the first central axis and the second central axis dividing the silicon substrate into a first region, a second region, a third region, and a fourth region; the plurality of mark points at least include a first mark point provided in the first region, a second mark point provided in the second region, a third mark point provided in the third region, and a fourth mark point provided in the fourth region, wherein the first mark points, the second mark points, the third mark points and the fourth mark points are sequentially connected to form a rectangle; and the center point of the rectangle serves as a datum point.

In some implementations, in the first doped region, the mark point has a first dimension in the first direction, and the first dimension is greater than a width of the first grid line and less than a width of the first doped region.

In some implementations, a ratio of the first dimension to the width of the first doped region is greater than 1/5 and less than or equal to 1/3.

In some implementations, in the second doped region, the mark point has a second dimension in the first direction, and the second dimension is greater than a width of the second grid line and less than a width of the second doped region.

In some implementations, a ratio of the second dimension to the width of the second doped region is greater than 1/5 and less than or equal to 1/3.

In some implementations, the silicon substrate further includes an isolation region provided between the first doped region and the second doped region, and at least some of the plurality of the mark points are provided in the isolation region.

In some implementations, in the isolation region, the mark point has a third dimension in the first direction, and the third dimension is less than a width of the isolation region.

In some implementations, a ratio of the third dimension to the width of the isolation region is greater than or equal to 1/3 and less than 1.

In some implementations, the plurality of first doped regions and the plurality of second doped regions are alternately arranged in parallel at intervals in the first direction, and the plurality of first grid lines and the plurality of second grid lines are alternately arranged in parallel at intervals in the first direction.

In some implementations, the first grid lines are provided at a central position of the first doped region, and the second grid line are provided at a central position of the second doped region.

In some implementations, a ratio of a width of the first grid line to a width of the first doped region is greater than 1/10 and less than or equal to 1/5, and a ratio of a width of the second grid line to a width of the second doped region is greater than 1/10 and less than or equal to 1/5.

In some implementations, each of the first grid lines, the second grid lines, and the mark points includes a glass slurry component; a mass percentage of the glass slurry component in the first grid lines is the same as a mass percentage of the glass slurry component in the mark points of the second doped region; and a mass percentage of the glass slurry component in the second grid lines is the same as a mass percentage of the glass slurry component in the mark points of the first doped region.

In some implementations, the mass percentage of the glass slurry component in the first grid lines and the mass percentage of the glass slurry component in the second grid lines are different.

In some implementations, the first grid line is a P-type grid line, the second grid line is an N-type grid line, and the mass percentage of the glass slurry component in the first grid line is greater than the mass percentage of the glass slurry component in the second grid line. Some of the plurality of mark points are provided above the first grid lines, and others of the plurality of mark points are provided below the second grid lines.

In some implementations, the first doped region includes a first doped layer, the second doped region includes a second doped layer, the first grid line is provided on the first doped layer and form an ohmic contact with the first doped layer, and the second grid line is provided on the second doped layer and form an ohmic contact with the second doped layer.

In some implementations, some of the plurality of mark points are provided on the first doped layer and isolated from the silicon substrate, and others of the plurality of mark points are provided on the second doped layer and isolated from the silicon substrate.

In some implementations, the solar cell further includes a first passivation layer provided on the first doping layer and a second passivation layer provided on the second doping layer, wherein a portion of the first grid line passes through the first passivation layer to contact the first doping layer, and a portion of the second grid line passes through the second passivation layer to contact the second doping layer.

In some implementations, some of the plurality of mark points are provided on the first passivation layer, some of the plurality of mark points pass through the first passivation layer to contact the first doping layer, others of the plurality of mark points are provided on the second passivation layer, and others of the plurality of mark points pass through the second passivation layer to contact the second doping layer.

In the present disclosure, some of the plurality of mark points are provided in the first doped region, and others of the plurality of mark points are provided in the second doped region; the mark points can be arranged in the second doped region when the first grid lines are printed; the mark points are arranged in the first doped region when the second grid lines are printed; and the mark points and the grid lines are printed step by step, thereby avoiding the problem that a mask at the mark point position is easily damaged, and improving the usage reliability of a screen.

The cell assembly includes the described solar cell. The technical effect of the present disclosure is the same as the technical effect of the described solar cell, and will not be repeated here.

### Brief Description of the Drawings

Fig. 1 is a structural front view of a solar cell according to the present disclosure;
Fig. 2 is a structural schematic diagram of a solar cell according to the present disclosure;
Fig. 3 is a first enlarged view of the structure A of Fig. 2;
Fig. 4 is a second enlarged view of the structure A of Fig. 2;
Fig. 5 is a first schematic diagram of a distribution structure of mark points of a solar cell according to the present disclosure;
Fig. 6 is a second schematic diagram of a distribution structure of mark points of a solar cell according to the present disclosure;
Fig. 7 is a third schematic diagram of a distribution structure of mark points of a solar cell according to the present disclosure;
Fig. 8 is a fourth schematic diagram of a distribution structure of mark points of a solar cell according to the present disclosure;
Fig. 9 is a fifth schematic diagram of a distribution structure of mark points of a solar cell according to the present disclosure;
Fig. 10 is a side view of a structure of a solar cell according to the present disclosure.

### Description of Reference Signs:

10. silicon substrate; 20. first grid line; 30. second grid line; 40. mark point; 50. first doped region; 60. second doped region; 70. isolation region; 80. first doped layer; 90. second doped layer; 100. first passivation layer; 110. second passivation layer.

### Detailed Description of the Embodiments

To make the objectives, technical solutions, and advantages of the present disclosure clearer, the present disclosure is further described in details below in combination with the drawings and embodiments. Examples of the embodiments will be illustrated in the accompanying drawings, wherein throughout the description, same or similar reference numerals represent same or similar elements or elements with same or similar functions. The embodiments described below with reference to the accompanying drawings are illustrative, and are intended to illustrate the present disclosure, and shall not be understood as limiting the present disclosure. In addition, it should be understood that the specific embodiments described herein are only used to explain the present disclosure, and are not intended to limit the present disclosure.

In the description of the present disclosure, it should be understood that, orientations or position relationships indicated by terms such as "length", "width", "upper", "lower", "left", "right", "horizontal", "top", "bottom" and the like are orientations or position relationships based on accompanying drawings and are only for the convenience of illustration of the specification and simplicity of illustration, rather than explicitly or implicitly indicate that apparatuses or components referred to herein must have a certain direction or be configured or operated in a certain direction and therefore cannot be understood as limitations to the present disclosure.

In addition, the terms "first" and "second" are only used for descriptive purposes, and cannot be understood as indicating or implying relative importance or implicitly indicating the number of indicated technical features. Thus, features defined by "first" and "second" may explicitly or implicitly include one or more of the features. In the description of the present disclosure, "a plurality of" refers to two or more than two, unless specified otherwise.

In the description of the present disclosure, it should be noted that, unless otherwise specified or defined, the terms such as "mount", "connected" and "connection" should be understood in a broad sense, for example, the connection may be a fixed connection, or a detachable connection, or an integral connection; may be a mechanical connection, may also be an electrical connection or may be an intercommunication; and may be a direct connection, an indirect connection through a medium, or a communication connection between two components or an interaction connection between two components. For those of ordinary skill in the art, the specific meanings of the above terms in the present disclosure can be understood according to specific situations.

In the present disclosure, unless specified or limited otherwise, a first feature being "above" or "below" a second feature may include a direct contact between the first feature and the second feature, and may also include another feature contact between the first feature and the second feature rather than a direct contact. In addition, the first feature being "above", "over", and "on" the second feature includes the first feature being right above and obliquely above the second feature or only refers to the first feature being at a higher horizontal level than the second feature. The first feature being "below", "underneath", and "under" the second feature includes the first feature being right below and obliquely below the second feature or only refers to the first feature being at a lower horizontal level than the second feature.

The following disclosure provides many different embodiments or examples for implementing different structures of the present disclosure. In order to simplify the disclosure of the present disclosure, components and settings of specific examples are described below. Of course, they are merely examples and are not intended to limit the present disclosure. Furthermore, the present disclosure may repeat reference numerals or reference letters or reference numerals and reference letters in different examples for the purpose of simplicity and clarity, and does not in itself indicate a relationship between the various embodiments or arrangements discussed or various embodiments and arrangements discussed. In addition, the present disclosure provides examples of various specific processes and materials, but those skilled in the art will recognize the application of other processes or the use of other materials or application of other processes and the use of other materials.

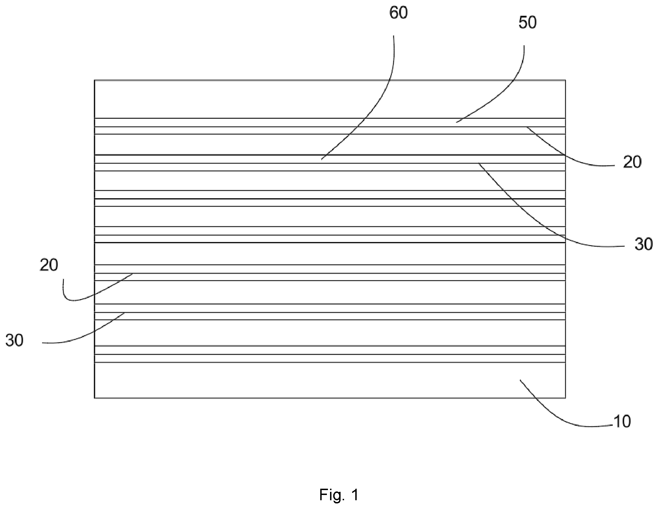

In the embodiments of the present disclosure, as shown in Figs. 1 to 3, a solar cell includes a silicon substrate 10, wherein the silicon substrate 10 may be a P-type silicon substrate 10, and may also be an N-type silicon substrate 10; and the silicon substrate 10 may be monocrystalline silicon or polycrystalline silicon. The specific type of the silicon substrate 10 is not limited herein. The silicon substrate 10 includes a plurality of first doped regions 50 and second doped regions 60 arranged in a staggered manner in a first direction, and in some implementations, the shapes and dimensions of the first region and the second region may be the same. For example, the first region and the second region are both rectangular, and the first region and the second region have the same length and width. It can be understood that, in other embodiments, the first region and the second region may have different shapes and dimensions. The plurality of first doped regions 50 and the plurality of second doped regions 60 being distributed in a staggered manner in the first direction means that, a second region is formed between two adjacent first regions in the first direction, the first region is formed between two adjacent second regions, the first doped regions 50 and the second doped regions 60 extend in a second direction, the first direction intersects with the second direction, and in the embodiment of the present disclosure, the second direction intersects with the first direction. In particular, the second direction may be perpendicular to the first direction. Exemplarily, the first direction may be a length direction of the silicon substrate 10, and the second direction may be a width direction of the silicon substrate 10.

Exemplarily, the doped region may be formed by introducing impurity atoms (such as phosphorus and boron) into a specific region of the silicon substrate 10 by means of ion implantation, diffusion or vapor deposition, etc., so as to form a doped source region. These impurity atoms change the conductivity of the silicon substrate 10, thereby forming the first doped region 50 or the second doped region 60.

In some embodiments, first grid lines 20 are provided in the first doped regions 50, second grid lines 30 are provided in the second doped regions 60, and the first grid lines 20 and the first doped regions 50 have the same polarity. In other words, if the first grid line 20 is a P-type fine grid line, the first doped region 50 is a P-type doped region; and if the first grid line 20 is an N-type fine gate, the first doped region 50 is an N-type doped region. The second grid lines 30 and the second doped regions 60 have the same polarity. In other words, if the second grid line 30 is a P-type fine grid line, the second doped region 60 is a P-type doped region; and if the second grid line 30 is an N-type fine grid line, the second doped region 60 is an N-type doped region. In addition, by means of a screen printing process, the first grid lines 20 may be provided on the first doped region 50 and the second grid lines 30 may be provided on the second doped region 60, wherein the first grid lines 20 and the second grid lines 30 may be printed sequentially or alternatively. The present disclosure does not limit the order of comparison. In this way, the positions of the first grid lines 20 and the second grid lines 30 are more accurate, so that the efficiency of arranging the first grid lines 20 and the second grid lines 30 is higher. It can be understood that, in other embodiments, a coating process may also be used to provide the first grid lines 20 on the first doped region 50 and provide the second grid lines 30 on the second doped region 60, which is not limited in the present disclosure.

In some implementations, the plurality of first doped regions 50 and the plurality of second doped regions 60 are alternately arranged in parallel at intervals in the first direction, and the plurality of first grid lines 20 and the plurality of second grid lines 30 are alternately arranged in parallel at intervals in the first direction. The alternating arrangement of the first doped regions 50 and the second doped regions 60 facilitates more effective collection and separation of photon-generated carriers, while the alternating arrangement of the first grid lines 20 and the second grid lines 30 optimizes the current transmission path, reduces resistance losses, improves current collection efficiency, and helps to achieve uniform current distribution on the cell, thereby reducing the risk of local overheating or performance degradation. In some implementations, the alternating arrangement of the doped regions and the grid lines helps to form a more stable cell structure, reducing performance degradation due to material mismatch or stress concentrations.

In the embodiment of the present disclosure, the first grid lines 20 are provided at a central position of the first doped region 50, and the second grid lines 30 are provided at a central position of the second doped region 60. The grid lines are located at the central positions of the doped regions, and can collect photo-generated carriers generated by the doped region more effectively. Such a layout ensures that the carriers can be quickly and directly transmitted to two electrodes of a battery by means of the grid lines, thereby reducing recombination losses during transmission. Since the grid lines are precisely placed at the central position of the doped region, this layout minimizes the blocking of incident light by the grid lines. Compared with the layout of the grid lines deviating from the center of the doped region, this design can capture more photons and convert same into electric energy, thereby improving the photoelectric conversion efficiency.

In some implementations, a ratio of a width of the first grid line 20 to a width of the first doped region 50 is greater than 1/10 and less than or equal to 1/5, and a ratio of a width of the second grid line 30 to a width of the second doped region 60 is greater than 1/10 and less than or equal to 1/5. In some implementations, a ratio of the width of the first grid line 20 to the width of the first doped region 50 is greater than 1/8 and less than or equal to 1/6, and a ratio of the width of the second grid line 30 to the width of the second doped region 60 is greater than 1/8 and less than or equal to 1/6. In the embodiment of the present disclosure, the appropriate increase of a width of the grid line helps to more effectively collect the photo-generated carriers generated by the doped regions. When the ratio of the width of the grid line to a width of the doped region is within the above range, it can ensure sufficient contact area between the grid line and the doped region, thereby reducing recombination losses of carriers during transmission. Although the grid lines may block part of the incident light, an appropriate ratio of the width of the grid line to the width of the doped region may balance the relationship between the light shielding loss and the current collection. An excessively narrow grid line may cause insufficient current collection, and an excessively wide grid line may increase shading loss. Within the above ratio range, a balance point can be found, it minimizes shading losses while ensuring sufficient current collection.

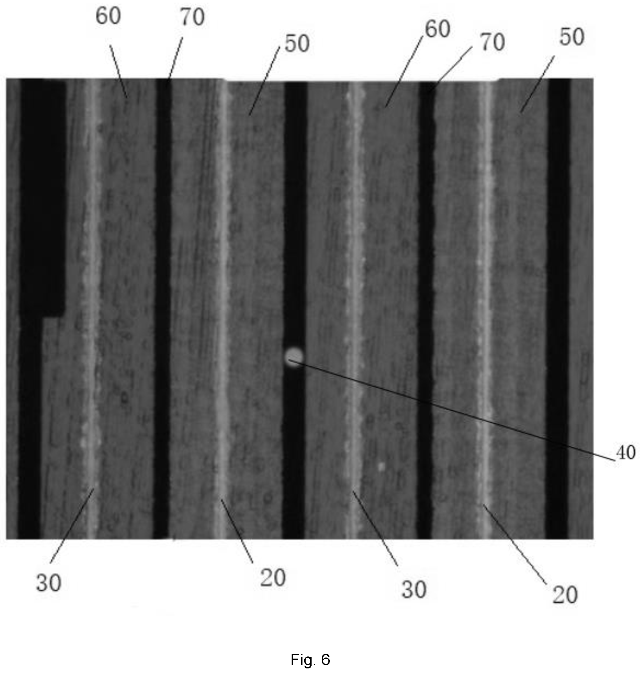

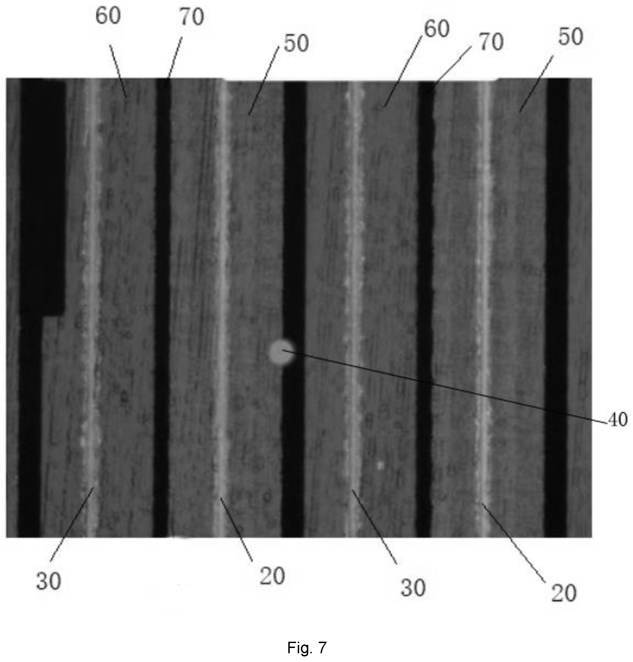

In some implementations, as shown in Fig. 1 to Fig. 9, the solar cell includes a plurality of mark points 40, some of the plurality of mark points 40 being provided in the first doped region 50, and others of the mark points 40 being provided in the second doped region 60. The mark point 40 serve as a positioning reference, and the mark points 40 are automatically identified by means of techniques such as machine vision, so that high-precision alignment can be ensured in a subsequent manufacturing process (such as printing and film coating).

In the present disclosure, some of the plurality of mark points 40 are provided in the first doped region 50, and others of the plurality of mark points 40 are provided in the second doped region 60; the mark points 40 can be arranged in the second doped region 60 when the first grid lines 20 are printed, and the mark points 40 can be arranged in the first doped region 50 when the second grid lines 30 are printed, that is to say, the mark points 40 of the second doped region 60 are synchronously screen-printed when the first grid lines 20 are printed, and the mark points 40 of the first doped region 50 are synchronously screen-printed when the second grid lines 30 are printed; compared to the previous method of synchronous screen-printing of the first grid lines 20 and the mark points 40 of the first doped region 50, or the synchronous screen-printing of the second grid lines 30 and the mark points 40 of the second doped region 60, the misaligned step-by-step printing of the grid lines and the mark points 40 in the same region are achieved, the problem that the mask at the position of the mark point 40 is easily damaged is avoided, and the usage reliability of a screen is improved.

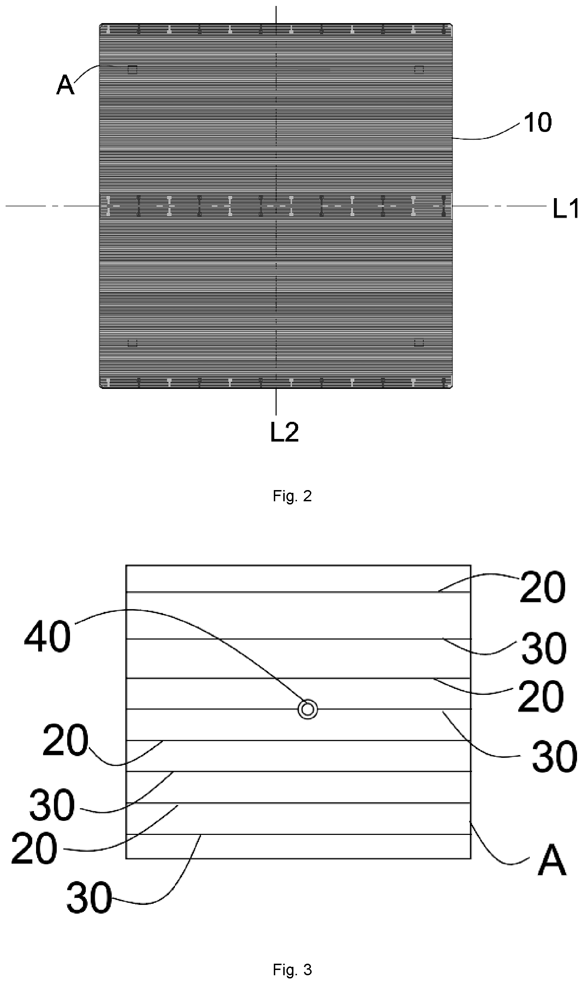

As shown in Figs. 2 and 3, in some implementations, the silicon substrate 10 has a first central axis L1 in the first direction; the silicon substrate 10 has a second central axis L2 in the second direction; the intersection of the first central axis L1 and the second central axis L2 divide the silicon substrate 10 into a first region, a second region, a third region and a fourth region; it can be understood that, the first region, the second region, the third region and the fourth region have the same size; and the first region, the second region, the third region and the fourth region respectively occupy four corners of the silicon substrate 10. The plurality of mark points 40 at least include a first mark point provided in the first region, a second mark point provided in the second region, a third mark point provided in the third region, and a fourth mark point provided in the fourth region, wherein the first mark point, the second mark point, the third mark point and the fourth mark point are sequentially connected to form a rectangle; and the center point of the rectangle serves as a datum point. Specifically, the number of mark points 40 may be four, six, or eight. Exemplarily, four mark points 40 are arranged in a rectangular pattern, with the sides of the rectangle being parallel to the edges of the silicon wafer, which can significantly simplify the calculation of printing position offsets while ensuring the precision of printing alignment. In the present embodiment, the position coordinate information of screen printing includes coordinate information of four aligned mark points 40, but is not limited thereto. Specifically, the method includes: a positioning system is started to perform image scanning on the solar cell in a laser device, so as to obtain a scanned image; the scanned image obtained by the positioning system is transmitted to an image processing unit, the mark points 40 on the surface of the solar cell is identified, the identified mark points 40 is calculated a datum point, and a positioning deviation of a central point of a silicon substrate 10 on the basis of the datum point is calculated; on the basis of the positioning deviation and the dimension parameters of the silicon substrate 10, an adaptive spot control system automatically adjusting the position of the laser working head to the initial position and sets the initial size and shape of the laser spot.

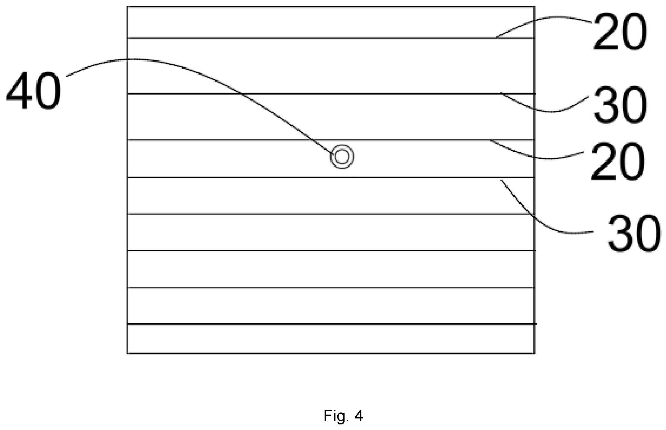

As shown in Figs. 4-7, in some implementations, at least some of the plurality of mark points 40 are provided between the first grid lines 20 and the second grid lines 30. That is to say, some of the plurality of mark points 40 are provided in the first doped region 50 or the second doped region 60; some of the plurality of mark points 40 are not in contact with the first grid lines 20 of the first doped region 50; some of the plurality of mark points 40 are not in contact with the second grid line 30 of the second doped region 60; and some of the plurality of mark points 40 are provided between the grid lines. Of course, in other embodiments, some of the mark points 40 may be provided between the grid lines, and others of the mark points 40 may be provided on the grid lines; and the positions of the mark points 40 may be flexibly arranged, which is not limited in the present disclosure.

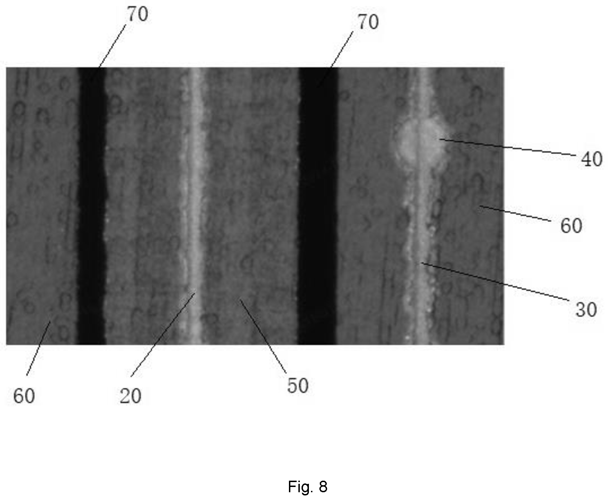

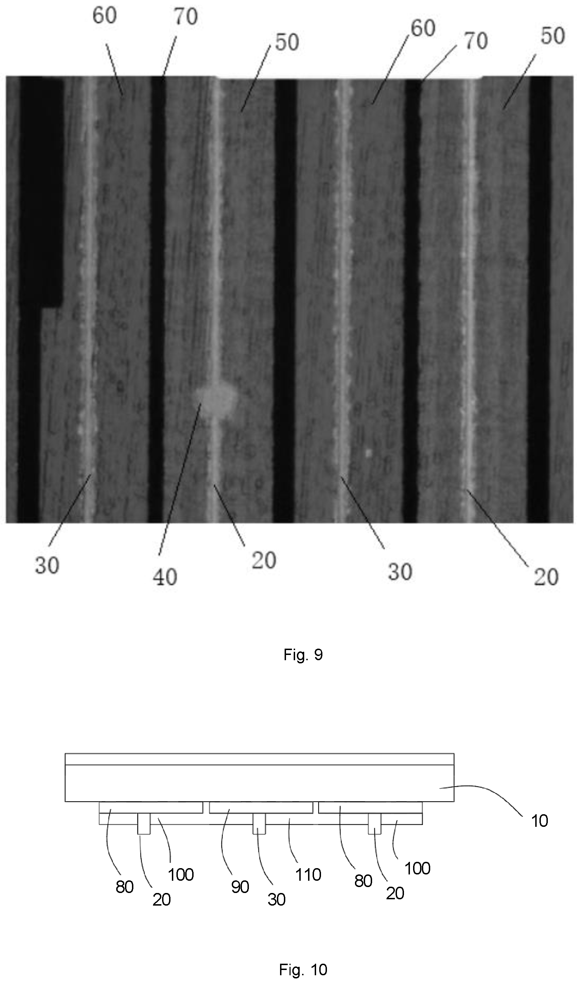

As shown in Figs. 8 and 9, in some implementations, some of the plurality of mark points 40 are provided below the first grid lines 20, and others of the plurality of mark points 40 are provided above the second grid lines 30. In the embodiments of the present disclosure, all of the mark points 40 are provided on the grid lines, some of the mark points 40 are provided below the first grid lines 20, and others of the mark points 40 are provided above the second grid lines 30; in some other embodiments, some of the plurality of mark points 40 are provided above the first grid lines 20, and others of the plurality of mark points 40 are provided below the second grid lines 30. In the embodiments of the present disclosure, all of the mark points 40 are provided on the grid lines, some of the mark points 40 are provided above the first grid lines 20, and others of the mark points 40 are provided below the second grid lines 30. That is to say, the mark points 40 and the grid lines in the same doping region are not on the same layer, and the grid lines and mark points 40 are designed in an overlapping structure, which allows the first grid lines 20 in the first doped region 50 and the mark points 40 in the first doped region 50 to be printed separately, and the second grid lines 30 in the second doped region 60 and the mark points 40 in the second doped region 60 to be printed separately. That is to say, the second grid lines 30 and the mark points 40 in the first doped region 50 are printed synchronously first, and then the first grid lines 20 and the mark points 40 in the second doped region 60 are printed synchronously. In this way, the mark points 40 in the first doped region 50 are provided below the first grid line 20, and the mark points 40 in the second doped region 60 are provided above the second grid line 30; first, the first grid lines 20 and the mark points 40 of the second doped region 60 are printed synchronously, and then the second grid lines 30 and the mark points 40 of the first doped region 50 are printed synchronously. In this way, the mark points 40 in the first doped region 50 are provided above the first grid lines 20, and the mark points 40 in the second doped region 60 are provided below the second grid lines 30. In the present disclosure, the first grid lines 20 in the first doped region 50 and the mark points 40 provided in the first doped region 50 are printed separately; the second grid lines 30 in the second doped region 60 and the mark points 40 provided in the second doped region 60 are printed separately; the mark points 40 can be provided on the second doped region 60 when printing the first doped region 50, and the mark points 40 can be provided on the first doped region 50 when printing the second doped region 60, thereby avoiding the problem that the mask at the position of the mark point 40 is easily damaged when the mark points 40 and the grid lines of p-type doped region or the gate lines of n-type doped region are printed synchronously.

In some implementations, in the first doped region 50, the mark point 40 has a first dimension in the first direction, and the first dimension is greater than the width of the first grid line 20 and less than the width of the first doped region 50. The mark point 40 serves as a positioning reference in the manufacturing process, and the design of the dimension thereof directly affects the positioning accuracy. When the first dimension of the mark point 40 is greater than the width of the first grid line 20, it can be ensured that the mark points 40 can be clearly distinguished from the grid lines when visual recognition or machine positioning is performed, thereby avoiding misidentification or positioning offset. Furthermore, this dimension is smaller than the width of the first doped region 50, which means that the mark point 40 does not occupy too many effective photoelectric conversion regions, thereby ensuring the overall performance and stability of the solar cell panel. Preferably, in the embodiment of the present disclosure, a ratio of the first dimension to the width of the first doped region 50 is greater than 1/5 and less than or equal to 1/3.

In some embodiments, in the second doped region 60, the mark point 40 has a second dimension in the first direction, and the second dimension is greater than the width of the second grid line 30 and less than the width of the second doped region 60. The mark point 40 serves as a positioning reference in the manufacturing process, and the design of the dimension thereof directly affects the positioning accuracy. When the first dimension of the mark point 40 is greater than the width of the second grid line 30, it can be ensured that the mark points 40 can be clearly distinguished from the grid lines when visual recognition or machine positioning is performed, thereby avoiding misidentification or positioning offset. Furthermore, this dimension is smaller than the width of the second doped region 60, which means that the mark point 40 does not occupy too many effective photoelectric conversion regions, thereby ensuring the overall performance and stability of the solar cell panel. Preferably, in the embodiment of the present disclosure, a ratio of the second dimension to the width of the second doped region 60 is greater than 1/5 and less than or equal to 1/3.

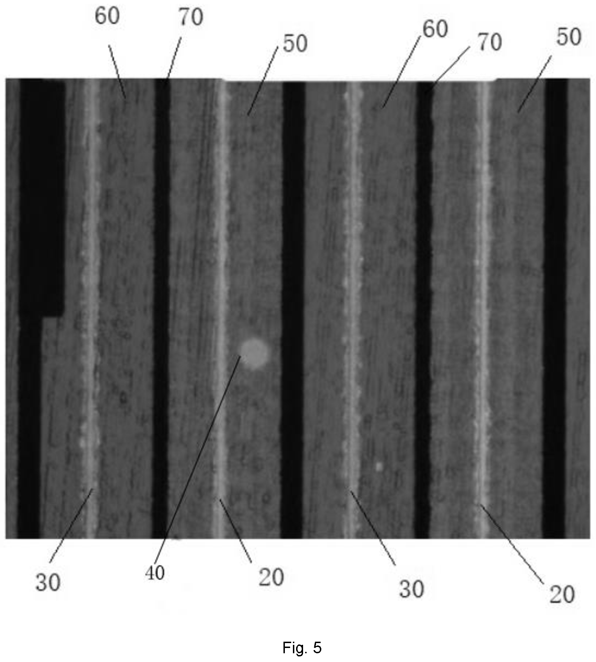

In some implementations, as shown in Figs. 5-9, the silicon substrate 10 further includes an isolation region 70 provided between the first doped region 50 and the second doped region 60, and at least some of the plurality of the mark points 40 are provided in the isolation region 70. The main function of the isolation region 70 is to provide electrical insulation between the first doped region 50 and the second doped region 60, so as to prevent a current between the two from flowing directly, thereby avoiding the occurrence of a short circuit phenomenon. Some of the plurality of mark points 40 may be provided in the isolation region 70, so that the space of the isolation region 70 may be effectively utilized, and the functions of positioning and marking may also be achieved. In some implementations, in the isolation region 70, the mark point 40 has a third dimension in the first direction, and the third dimension is less than a width of the isolation region 70. In the embodiment of the present disclosure, the mark points 40 are provided in the isolation region 70 and the dimension thereof is controlled to be less than the width of the isolation region 70, it is possible to prevent mark points 40 in the isolation region 70 from causing connection between the adjacent first doped region 50 and second doped region 60, thereby avoiding localized short circuits in the solar cell. Preferably, in the embodiment of the present disclosure, a ratio of the third dimension 70 to the width of the isolation region is greater than or equal to 1/3 and less than 1. When the third dimension accounts for at least 1/3 of the width of the isolation region 70, it ensures that the mark point 40 has a sufficient feature size during the positioning process, thereby reducing positioning errors. Since the size of the mark point 40 does not reach a full width of the isolation region 70, the potential impact on the electrical performance and physical integrity of the isolation region 70 during the fabrication of the mark points 40 is relatively small. This helps to maintain the stability and reliability of the isolation region 70.

In some embodiments, as shown in Figs. 1 and 10, the first doped region 50 includes a first doped layer 80, the second doped region 60 includes a second doped layer 90, the first grid line 20 is provided on the first doped layer 80 and form an ohmic contact with the first doped layer 80, and the second grid line 30 is provided on the second doped layer 90 and form an ohmic contact with the second doped layer 90. In the embodiment of the present disclosure, the first grid lines 20 are configured to collect and transmit carriers of the first doped layer 80; the second grid lines 30 are configured to collect and transmit carriers of the second doped layer 90; and the carriers collected by the first grid lines 20 and the second grid lines 30 transmit current to an external circuit by means of a metal wire.

In some embodiments, as shown in Figs. 3, 4 and 10, some of the plurality of mark points 40 are provided on the first doped layer 80 and isolated from the silicon substrate 10, and others of the plurality of mark points 40 are provided on the second doped layer 90 and isolated from the silicon substrate 10. The mark points 40 serves as the positioning reference, which can ensure that in a subsequent production process (such as printing, cutting and packaging), various layers or components can be precisely aligned, and the mark points 40 are provided on the doped layer and isolated from the silicon substrate 10, thereby preventing the mark points 40 from contaminating the silicon substrate 10 in the printing process.

A cell assembly further includes a first passivation layer 100 provided on the first doping layer 80 and a second passivation layer 110 provided on the second doping layer 90, wherein a portion of the first grid line 20 passes through the first passivation layer 100 to contact the first doping layer 80, and a portion of the second grid line 30 passes through the second passivation layer 110 to contact the second doping layer 90. The first grid lines 20 and the second grid lines 30 respectively pass through the passivation layer and the doped layer thereof to contact with the electrode, thereby realizing effective collection of carriers.

In some embodiments, some of the plurality of mark points 40 are provided on the first passivation layer 100, some of the plurality of mark points 40 pass through the first passivation layer 100 to contact the first doping layer 80, others of the plurality of mark points 40 are provided on the second passivation layer 110, and others of the plurality of mark points 40 pass through the second passivation layer 110 to contact the second doping layer 90. When the mark points 40 pass through the passivation layer and contact the doped layer, they may serve as additional current collection channels, and help to reduce recombination loss of carriers during transmission, thereby improving the photoelectric conversion efficiency.

Certainly, in other embodiments, some of the plurality of mark points 40 are provided on the first passivation layer 100 and isolated from the first doped layer 80, while others of the plurality of mark points 40 are provided on the second passivation layer 110 and isolated from the second doped layer 90. The mark points 40 only need to serve as identifiers for observation and do not conduct current. It is not limited in the present disclosure.

In some embodiments, each of the first grid lines 20, the second grid lines 30, and the mark points 40 includes a glass slurry component; a mass percentage of the glass slurry component in the first grid lines 20 is the same as a mass percentage of the glass slurry component in the mark points 40 of the second doped region; and a mass percentage of the glass slurry component in the second grid lines 30 is the same as a mass percentage of the glass slurry component in the mark points 40 of the first doped region.

In the present disclosure, it is arranged such that the mass percentage of the glass slurry component in the first grid lines 20 is the same as the mass percentage of the glass slurry component in the mark points 40 of the second doped region; the mass percentage of the glass slurry component in the second grid lines 30 is the same as the mass percentage of the glass slurry component in the mark points 40 of the first doped region; the mark points 40 in the second doped region can be printed simultaneously when the first grid lines 20 are printed; the mark points 40 in the first doped region can be printed simultaneously when the second grid lines 30 are printed; the misaligned step-by-step printing of the mark points 40 and the grid lines in the same doped region are printed are achieved; so that the problem that a mask at the position of the mark point 40 is easily damaged is avoided, and the usage reliability of a screen is improved.

In other embodiments, each of the first grid line 20, the second grid line 30, and the mark point 40 further includes a conductive component, a doping component, and an organic carrier. In this way, each of the first grid line 20, the second grid line 30, and the mark point 40 can have conductivity and a doping type by means of the conductive component and the doping component, and can perform paste modification by means of the glass slurry component, thereby achieving the effect of low recombination. The first grid lines 20 and the mark points 40 in the second doped region use the same slurry, i.e. the first slurry; the second grid lines 30 and the mark points 40 in the first doped region use the same slurry, i.e. the second slurry; in the first slurry, the mass percentage of a first conductive component is 70%-88%, the mass percentage of a first doping component is 0.2%-18%, the mass percentage of a first organic carrier component is 0.2%-18%, and the mass percentage of a first glass slurry component is 0.1%-10%; in the second slurry, the mass percentage of a second conductive component is 70%-88%, the mass percentage of a second doping component is 0.2%-18%, the mass percentage of a second organic carrier component is 0.2%-18%, and the mass percentage of a second glass slurry component is 0.1%-10%. Specifically, the conductive component includes at least one of silver particles, aluminum particles, copper particles, nickel particles, or tin particles; the doping component includes at least one of boron nitride, elemental aluminum, elemental gallium, gallium oxide, gallium hydroxide, gallium salts, elemental nickel, nickel oxide, or nickel salts; the organic carrier component includes at least one of organosilicon, silica gel, or rosin alcohol; and the glass slurry component includes at least one of lead glass, bismuth glass, borate glass, or zinc glass. It is not limited in the present disclosure.

In some embodiments, the mass percentage of the glass slurry component in the first grid lines 20 and the mass percentage of the glass slurry component in the second grid lines 30 are different. Preferably, the first grid line is a P-type grid line; the second grid line is an N-type grid line; the mass percentage of the glass slurry component in the first grid line is greater than the mass percentage of the glass slurry component in the second grid line; the slurry of the first grid line 20 is a P-type slurry; and the slurry of the second grid line is an N-type slurry. In this way, the mass percentage of the glass component in the P-type slurry is greater than that in the N-type slurry. Since the thickness of the poly layer in the P-type region is greater than that in the N-type region, this design allows the P-type slurry to form better electrical contact with the P-type poly layer.

The cell assembly, it includes the described solar cell. On the basis of providing the described solar cell, a person skilled in the art would have been aware that a corresponding cell assembly can be obtained by means of a plurality of solar cells or other corresponding existing accessories or a plurality of solar cells and other corresponding existing accessories.

In the illustration of the description, the illustration of reference terms "an embodiment", "some embodiments", "an example", "a specific example", or "some examples" means that specific features, structures, materials, or characteristics described in connection with the embodiment or example is included in at least one embodiment or example the present disclosure. In the description, the illustrative expressions of the described terms do not necessarily refer to the same embodiment or example. Furthermore, the specific features, structures, materials, or characteristics described may be combined in any suitable manner in one or more embodiments or examples.

The described content merely relates to preferred embodiments of the present disclosure, and is not intended to limit the present disclosure, and any modifications, equivalent replacements, improvements, etc. made within the spirit and principle of the present disclosure shall all fall within the scope of protection of the present disclosure.

## Claims

1. A solar cell, comprising a silicon substrate, wherein the silicon substrate comprises: a plurality of first doped regions and second doped regions distributed in a staggered manner in a first direction, the first doped region and the second doped region extend in a second direction, the first direction intersects with the second direction; first grid lines are provided in the first doped region, and second grid lines are provided in the second doped region; a plurality of mark points, some of the plurality of mark points being provided in the first doped region, and others of the mark points being provided in the second doped region.

2. The solar cell according to claim 1, wherein at least some of the plurality of mark points are provided between the first grid lines and the second grid lines.

3. The solar cell according to claim 1, wherein some of the plurality of mark points are provided below the first grid lines, and others of the plurality of mark points being provided above the second grid lines.

4. The solar cell according to claim 1, the silicon substrate has a first central axis in the first direction and a second central axis in the second direction, with the intersection of the first central axis and the second central axis dividing the silicon substrate into a first region, a second region, a third region, and a fourth region; the plurality of mark points at least comprise a first mark point provided in the first region, a second mark point provided in the second region, a third mark point provided in the third region, and a fourth mark point provided in the fourth region, wherein the first mark point, the second mark point, the third mark point and the fourth mark point are sequentially connected to form a rectangle; and the center point of the rectangle serves as a datum point.

5. The solar cell according to claim 1, wherein in the first doped region, the mark point has a first dimension in the first direction, and the first dimension is greater than a width of the first grid line and less than a width of the first doped region.

6. The solar cell according to claim 5, wherein a ratio of the first dimension to the width of the first doped region is greater than 1/5 and less than or equal to 1/3.

7. The solar cell according to claim 1, wherein in the second doped region, the mark point has a second dimension in the first direction, and the second dimension is greater than a width of the second grid line and less than a width of the second doped region.

8. The solar cell according to claim 7, wherein a ratio of the second dimension to the width of the second doped region is greater than 1/5 and less than or equal to 1/3.

9. The solar cell according to claim 1, wherein the silicon substrate further comprises an isolation region provided between the first doped region and the second doped region, and at least some of the plurality of the mark points are provided in the isolation region.

10. The solar cell according to claim 9, wherein in the isolation region, the mark point has a third dimension in the first direction, and the third dimension is less than a width of the isolation region.

11. The solar cell according to claim 10, wherein a ratio of the third dimension to the width of the isolation region is greater than or equal to 1/3 and less than 1.

12. The solar cell according to claim 1, wherein the plurality of first doped regions and the plurality of second doped regions are alternately arranged in parallel at intervals in the first direction, and the plurality of first grid lines and the plurality of second grid lines are alternately arranged in parallel at intervals in the first direction.

13. The solar cell according to claim 12, wherein the first grid lines are provided at a central position of the first doped region, and the second grid line are provided at a central position of the second doped region.

14. The solar cell according to claim 1, wherein a ratio of a width of the first grid line to a width of the first doped region is greater than 1/10 and less than or equal to 1/5, and a ratio of a width of the second grid line to a width of the second doped region is greater than 1/10 and less than or equal to 1/5.

15. The solar cell according to claim 1, wherein each of the first grid lines, the second grid lines, and the mark points comprises a glass slurry component; a mass percentage of the glass slurry component in the first grid lines is the same as a mass percentage of the glass slurry component in the mark points of the second doped region; and a mass percentage of the glass slurry component in the second grid lines is the same as a mass percentage of the glass slurry component in the mark points of the first doped region.

16. The solar cell according to claim 15, wherein the mass percentage of the glass slurry component in the first grid lines and the mass percentage of the glass slurry component in the second grid lines are different.

17. The solar cell according to claim 16, wherein the first grid line is a P-type grid line, the second grid line is an N-type grid line, and the mass percentage of the glass slurry component in the first grid line is greater than the mass percentage of the glass slurry component in the second grid line.

18. The solar cell according to claim 15, wherein some of the plurality of mark points are provided above the first grid lines, and others of the plurality of mark points are provided below the second grid lines.

19. The solar cell according to claim 15, wherein the first doped region comprises a first doped layer, the second doped region comprises a second doped layer, the first grid line is provided on the first doped layer and form an ohmic contact with the first doped layer, and the second grid line is provided on the second doped layer and form an ohmic contact with the second doped layer.

20. The solar cell according to claim 19, wherein some of the plurality of mark points are provided on the first doped layer and isolated from the silicon substrate, and another portion of the plurality of mark points is provided on the second doped layer and isolated from the silicon substrate.

21. The solar cell according to claim 19, wherein the solar cell further comprising a first passivation layer provided on the first doping layer and a second passivation layer provided on the second doping layer, wherein a portion of the first grid line passes through the first passivation layer to contact the first doping layer, and a portion of the second grid line passes through the second passivation layer to contact the second doping layer.

22. The solar cell according to claim 21, wherein some of the plurality of mark points are provided on the first passivation layer, some of the plurality of mark points pass through the first passivation layer to contact the first doping layer, others of the plurality of mark points are provided on the second passivation layer, and others of the plurality of mark points pass through the second passivation layer to contact the second doping layer.

23. A cell assembly, comprising the solar cell according to any one of claims 1 to 22.
